Europäisches Patentamt

European Patent Office

Office européen des brevets

(19)

(11) Veröffentlichungsnummer: **0 293 719**
**A1**

## EUROPÄISCHE PATENTANMELDUNG

(21) Anmeldenummer: 88108250.7

(22) Anmeldetag: 24.05.88

(51) Int. Cl.⁴: **C23C 16/18** , **C23C 16/16** , **H05K 3/10** , **H05K 3/24** , **H01L 21/31**

(30) Priorität: 25.05.87 DE 3717955

(43) Veröffentlichungstag der Anmeldung:
07.12.88 Patentblatt 88/49

(84) Benannte Vertragsstaaten:
BE CH DE ES FR GB IT LI LU NL SE

(71) Anmelder: SCHERING AKTIENGESELLSCHAFT
Berlin und Bergkamen
Müllerstrasse 170/178 Postfach 65 03 11
D-1000 Berlin 65(DE)

(72) Erfinder: Suhr, Harald, Prof. Dr.rer.nat.
Weissdornweg 2
D-7400 Tübingen(DE)
Erfinder: Schmidt, Rainer, Dipl.-Chem.
Wöhrwoldweg 43
D-7410 Reutlingen(DE)

(54) Verfahren zur Herstellung von dünnen Molybdän-Filmen durch Abscheidung in Glimmenladungszonen.

(57) Die Erfindung betrifft ein Verfahren zur Herstellung von dünnen Molybdän-Filmen, bei denen die elektrische Leitfähigkeit in großen Grenzen variiert und auf gewünschte Werte eingestellt werden kann, dadurch gekennzeichnet, daß eine molybdän-organische Verbindung in Gasform in eine Glimmentladungszone zersetzt wird.

EP 0 293 719 A1

# VERFAHREN ZUR HERSTELLUNG VON DÜNNEN MOLYBDÄN-FILMEN DURCH ABSCHEIDUNG IN GLIMMENTLADUNGSZONEN

Die Erfindung betrifft ein Verfahren zur Herstellung von dünnen Molybdän-Filmen, bei denen bei elektrische Leitfähigkeit in großen Grenzen variiert und auf gewünschte Werte eingestellt werden kann.

Es sind bereits Verfahren zur Herstellung dünner Molybdän-Schichten bekannt. Diese beruhen hauptsächlich auf der Pyrolyse flüchtiger Mo-Verbindungen, unter anderem auch des Molybdänhexacarbonyls, das bei der Entwicklung dieses Verfahrens eingesetzt wurde. So führten Lander und Germer (1) bereits vor 40 Jahren umfangreiche Pyrolyseexperimente mit Hexacarbonylen ($M(CO)_6$, M = Cr,Mo,W) der VI. Nebengruppe durch. In ihren Veröffentlichungen beschreiben sie unter anderem die thermische Zersetzung von $Mo(CO)_6$ bei Temperaturen von 350-700° C. Dabei werden erhitzte Metallsubtrate (Kupfer, Eisen, verschiedene Stähle) bei verminderten Drücken mit gasförmigem $Mo(CO)_6$ in Kontakt gebracht, worauf sich dünne MO-Filme im $\mu$-Bereich abscheiden. Die dabei gemäß $Mo(CO)_6 \longrightarrow Mo + 6CO$ erhaltenen Molybdänfilme sind jedoch nur bei einer Temperatur von exakt 550° C von hoher Reinheit. Schon geringe Temperaturschwankungen führen zu stark kohlenstoffhaltigen Molybdänschichten (Bildung verschiedener Carbidmodifikationen).

Die geringe Bandbreite bezüglich der Temperaturvariation sowie die hohen Substrattemperaturen an sich schließen dieses Verfahren für heutige Zwecke nahezu aus.

Seraphin et al.(2),(3),(4),(5) beschreiben einen Weg zur Darstellung des sog. "black molybdenum", das einne höhere UV-Absorption als reines Molydbän besitzt. Es handelt sich dabei um einen Pyrolseprozess, der in Gegenwart von Sauerstoff durchgeführt wird, wobei Filme entsstehen, deren Morphologie von den Autoren als Einbettung von Molybdän in eine $MoO_2$ Matrix beschrieben wird. Als Ausgangsmaterial dient $Mo(CO)_6$, des weiten $MoCl_5$ sowie $MoO_2Cl_2$ verwendet, teilweise unter Zusatz von Wasserstoff. Die für dieses Verfahren notwendigen Temperaturen liegen je nach Ausgangsverbindung zwischen 500 und 700° C.

Verständlicherweise kann dieses Verfahren nur auf thermisch sehr stabile Substrate angewendet werden. Außerdem entsteht beim Einsatz halogenhaltiger Ausgangsmaterialien zusatzlich Chlorwasserstoff, welcher einerseits korrosionsbeständige, gegen HCl inerte Substrate voraussetzt, andererseits die mechanische Belastung der Apparatur enorm steigert.

Von einem plasma-unterstützes Verfahren zur Beschichtung von Stahlsubstraten berichten Sheward und Young (6). Danach werden Substrate aus Kanonenstahl bei ca 400° C in einer 1-2KV-Hochspannungsentladung bei Drucken 1 Torr mit Mo beschichtet. Als Mo-Quelle dient $Mo(CO)_6$, das zusammen mit einer $Ne/H_2$-Trägergasmischung dem Reaktorraum zugeführt wird. Die bis zu 10 m dicken Mo-Filme enthalten zum Teil beträchtliche Mengen an Kohlenstoff. Außerdem wird von einer kohlestaubartigen Bedeckung der Substrate berichtet, was auf eine plasmachemisch inhomogene Reaktionsführung hindeutet. Normalerweise ist das Auftreten von freiem Kohlenstoff ein Indiz für unerwünschte Gasphasenreaktionen. Auf diese Weise erhaltene Filme besitzen erfahrungsgemäß eine amorphe Zusammensetzung sowie eine - schlechte Haftfestigkeit.

Auch Okuyama (7), (8) setzte $Mo(CO)_6$ einer Hochspannungsentladung aus bei seinem Versuch, auf einer Kathodenspitze Mo-Nadeln zu züchten. Bei seinen in einem Parallelplattensystem durchgeführten Versuchen erhält man jedoch nur stark kohlenstoffhaltige Filme (C-Gehalt zwischen 20 und 30 at%).

Chu, Tang und Hess (9), (10) führten PECVD-Versuche (Plasma ehanced chemical vapor deposition) mit $MoF_6/H_2$-Gemischen zur Darstellung von Mo-Schichten durch. Die auf diesem Wege dargestellten Filme sind jedoch für industrielle Zwecke vollkommen unbrauchbar, da sie große Fluor-Anteile besitzen und Widerstände $10^4$ $\mu\Omega$cm aufweisen.

Ein weiteres PECVD-Verfahren auf der Basis eines $MoCl_5/H_2$-Gemisches wird von Tabuchi et al. (11) beschrieben.

Diese bei Drücken um 133Pa und bei Temperaturen zwischen 170 und 430° C durchgeführten Versuche führen jedoch nur zu amorphen Filmen, die durch Sauerstoff und Chlor verunreinigt sind. Erst durch eine Nachbehandlung bei Temperaturen um 800° C in einer $N_2$-Atmosphäre (Annealing) werden brauchbare Mo-Schichten erhalten, wodurch die Anwendung dieses Verfahrens eingeschränkt wird.

Aufgabe der vorliegenden Erfindung ist es, dünne metallische, elektrisch leitfähige Mo-Filme von guter Haftfestigkeit in Glimmentladungszonen herzustellen, wobei als Ausgangsmaterial eine metallorganische Verbindung ($Mo(CO)_6$ benutzt wird.

Diese Aufgabe wird erfindungsgemäß durch das Verfahren gemäß dem kennzeichnenden Teil des Patentanspruchs gelöst.

Vorteilhafte Weiterentwicklungen sind in den Unteransprüchen gekennzeichnet.

Die Erfindung ermöglicht es insbesondere, ein hochschmelzendes Metall wie Molybdän (Fp. 2626 °C) unter vergleichsweise milden Bedingungen ($T_{Substr.}$ = 100 - 200 °C) bei optimaler Haftung auf thermisch stabile wie labile Substrate aller Art aufzutragen. Neben diesem, vor allem für die Mikroelektronik interessanten Aspekt, kann sie auch zur Erzeugung korrosionsbeständiger Überzüge von Werkstoffen eingesetzt werden. Schließlich ist sie zur Herstellung von Ir-Reflektoren, zum Beispiel in Solarzellen als Ersatz teurer Silberspiegel von großer Bedeutung.

Das hier zugrunde liegende erfindungsgemäße Verfahren ist den bisher bekannten nicht nur ebenbürtig, sondern stellt in vielerlei Hinsicht eine Weiterentwicklung dar. Da die Substrattemperaturen nur ca. 100-200 °C betragen, ist es insbesondere möglich auch gegen hohe Temperaturen empfindliche Substrate wie beispielsweise 50 m-Polyimidfolien oder handelsübliche Epoxidplatten mit einem elektrisch leitenden, metallischen Mo-Film variabler Schichtdicke zu belegen, ohne daß diese in irgend einer Form beschädigt werden. Auch rein physikalische Methoden wie zum Beispiel die Kathodenzerstäubung können wegen zu hoher Energiedichten hier nicht eingesetzt werden.

Die Haftfestigkeit der nach diesem erfindungsgemäßen Verfahren hergestellten Schichten ist außergewöhnlich gut. Diese Tatsache ist vor allem bezüglich Glas, glasartigen Schstratmaterialien und Quarz signifikant. Bei anderen Verfahren müssen hier zur Realisierung einer ausreichenden Adhäsion häufig sogenannte Adhäsionspromoter oder Leimschichten eingesetzt werden. Eine weitere Besonderheit besteht darin, daß die elektrische Leitfähigkeit innerhalb großer Grenzen variiert werden kann. Auch ist es möglich, ohne externe Zudosierung von Sauerstoff oxidhaltige Filme zu erzeugen. Man ist also in der Lage einfach durch Steuerung der Verfahrensparameter die Filmeigenschaften den jeweiligen Bedürfnissen anzupassen.

Diese besonderen Vorzüge des erfindungsgemäßen Verfahrens basieren auf dem Mechanismus der Filmbildung.

Im Gegensatz zu den bekannten Verfahren wird das metalltragende organische Molekül zunächst auf der Substratoberfläche absorbiert und erst dann durch Wechselwirkung mit dem Plasma und seinem Ionen-, Elektronen- und Photonenbombardement in das Metall überführt. Dabei wird durch das Plasma sowohl das Substrat angeätzt als auch die metallorganische Verbindung -abhängig von der Intensität und Dauer der Einwirkung - in mehr oder weniger metallische Fragmente zerlegt. Dabei werden nach einem komplizierten Mechanismus C-haltige, C-und 0-haltige, 0-haltige oder reine Mo-Filme erhalten.

Diese Tatsache, verbunden mit einer einfachen Steuerung durch Einstellung bestimmter Arbeitsparameter ermöglicht eine maßgeschneiderte Herstellung von dünnen Mo-Filmen für verschiedenste Anwendungsgebiete.

Zur Durchführung des erfindungsgemäßen Verfahrens können normale Plasmareaktoren benutzt werden, die hauptsächlich als Rohr- beziehungsweise Tunnelreaktoren oder als Parallelplattenreaktoren bekannt sind. Das Plasma kann sowohl mit Gleichstrom als auch mit Wechselstrom oder hochfrequentem Strom erzeugt werden.

Der Druck in der Plasmakammer beträgt im allgemeinen 5-100Pa, es wird also -dies ist auch ein erheblicher Vorteil gegenüber der Kathodenzerstäubung oder des Bedampfens -kein Hochvakuum mit Drücken von weniger als 3 Pa benötigt, die entsprechende Anforderungen an die Vakuumanlage stellen. Als Substrate, auf denen die Mo-Filme abgeschieden werden können, kommen in erster Linie alle üblichen anorganischen oder organischen Nichtleiter in Frage, insbesondere Aluminiumoxidkeramiken, Siliziumoxidkeramiken, Nitrickeramiken, Glas, Quarzglas, Quarz, Metalle mit Oxid- oder Nitridschichten oder Kunststoffe. Es können weiterhin auch reine Metalle als Substrate eingesetzt werden.

Als metallorganische Verbindung zur Herstellung von Mo-Schichten ist das Molybdänhexacarbonyl besonders geeignet, da es unter den angewandten Vakuumbedingungen bereits RT genügend flüchtig beziehungsweise sublimierbar ist. Es ist luftbeständig, leicht zu handhaben beziehungsweise bequem zu dosieren und infolge seines latenten Sauerstoffs auch zur Herstellung oxidischer Filme geeignet. Da keine korrosiven Nebenprodukte entstehen, werden an die Apparatur keine besonderen Ansprüche gestellt. Die Einspeisung in die Glimmentladungszone erfolgt nach Herstellung des Vakuums zusammen mit einem Trägergas beziehungsweise Trägergasgemisch, so daß im eigentlichen Reaktionsbereich eine gleichmäßige Gasmischung vorliegt. Der Vorratsbehälter für die Metallverbindung wurde zweckmäßigerweise mit einer Heizvorrichtung versehen, um versuchsweise auch höhere Partialdampfdrücke realisieren zu können.

Als Trägergase sind inerte Gase wie Argon oder Helium, reduzierende Gase wie Wasserstoff, oder deren Gemische geeignet.

Folgendes Beispiel, bei dem ein Parallelplattenreaktor benutzt wurde, dient zur Erläuterung der Erfindung.

## BEISPIEL

Substrat        -Silikat- oder Quarzglas
Metallorganische Verbindung       -Mo(CO)$_6$
Trägergas        -Argon/Wasserstoff 2:1
Gasfluß        -Ar:5sccm (Standard-cm$^3$ / min),
H$_2$:2,5sccm
Elektrodentemperatur        -175°C
Heizung des Vorratsbehälters        -entfällt
Frequenz        -HF(13,56 MHz)
Leistungsdichte        -0,6 Watt/cm$^2$
Druck im Reaktor        -20 Pa
Reaktionsdauer        -60 min für 0,1 m Filmdicke

Unter den angegebenen Arbeitsbedingungen wurden nacheinander auch verschiedene andere Substrate Aluminiumoxid, Keramik, Epoxidharz, Aluminiumnitrid, Polyimid, auch als Folie beschichtet, wobei jedesmal metallische, elektrisch leitende Filme von ca. 1000A Schichtdicke entstanden.

An den abgeschiedenen Mo-Schichten wurden anschließend die spezifischen elektrischen Widerstände nach der Vierpunkt-Methode mit einem Gerät von Kulicke und Soffa, Modell 331, gemessen. Für die auf Glas beziehungsweise Quarzglas erzeugten Schichten ergaben sich Werte von ca. 100μΩcm. Eine Überprüfung dieser Werte nach mehrwöchigem Stehenlassen an feuchter Luft zeigte keine Veränderungen. Diese Werte wurden mit sogenannten "as deposited" Filmen erzielt, das heißt so wie unter den gegebenen Bedingungen im Reaktor entstanden. Ein wie bei anderen Verfahren zur Realisierung guter Widerstandswerte meist notwendiges Annealing (nachträgliche Wärmebehandlung zur Verbesserung der Kristallstruktur, bei Mo ca. 700-800°C) muß hier nicht durchgeführt werden.

Die Metallgehalte der so hergestellten Mo-Filme betragen 95-100 Gew.%. Die Kohlenstoffgehalte liegen bei max. 5 Gew.%.

Die Haftfestigkeit auf Glas wurde durch Abreißen eines ca. 4mm breiten Cu-streifens ermittelt, der mit Hilfe eines 2-Komponenten-Klebers aufgebracht wurde. Die Probe wurde vor dem Abreißen 24h bei 100°C getrocknet, was lt. Angaben des Herstellers einer Zugfestigkeit von mindestens 120Kp/cm$^2$ entspricht.

Wird die Reaktionsdauer auf 45 min. verkürzt, verringert sich die Schichtdicke auf ca. 500A. Wird die Leistungsdichte um ein Drittel verringert, steigt der elektrische Widerstand um etwa eine Zehnerpotenz bedingt durch den verstärkten Einbau von Kohlenstoff.Derselbe Effekt zeigt sich, wenn man bei unveränderter Leistungsdichte in einer reinen Argon-Entladung arbeitet.

Dieses Phänomen kann durch Senkung der Substrattemperatur beziehungsweise durch weitere Reduzierung der Leistungsdichte noch verstärkt werden. Wird die Leistungsdichte um ca. ein Drittel oder mehr erhöht, steigt der elektrische Widerstand ebenfalls, da nun oxidhaltige Mo-Filme gebildet werden.

Man erhält also allgemein durch Änderung der Leistungsdichten beziehungsweise der Gasgemische Mo-Filme, deren Widerstände über mehrere Zehnerpotenzen wählbar sind.

## LITERATURVERZEICHNIS

1 J.J.Lander and L.H.Germer, Trans AIME 175,648 (1948)

2 B.O.Seraphin,J.Vac.Sci.Technol. 16(2),193-(1979)

3 B.O.Seraphin,Thin Solid Films 57,293-(1979)

4 H.S.Gurev,G.E.Carver,B.O.Seraphin,Proc.Int.Symp.-Sol. Energy, 36-49 (1976)

5 E.E.Chain,K.A.Gesheva and B.O.Seraphin,Thin Solid Films 83,387 (1981)

6 J.A.Sheward and W.J.Young, Vacuum 36-(1-3), 37(1986)

7 F.Okuyama,Appl.Phys.22,39 (1980)

8 F.Okuyama, Appl.Phys.A28, 125(1982)

9 J.K.Chu,C.C. Tang and D.W.Hess,Appl.Phys.Lett.41,75 (1982)

10 C.C.Tang,J.K.Chu and D.W.Hess,Solid State Technol.26(3),125 (1983)

11 A.Tabuchi,S..Inoue,M.Maeda and M.Takagi,Proceedings of the 23rd Symposium on Semiconductors and IC Technology of the Electrochemical Society of Japan, 1982,p60

## Ansprüche

1. Verfahren zur Herstellung von dünnen Molybdän-Filmen, bei denen die elektrische Leitfähigkeit in großen Grenzen variiert und auf gewünschte Werte eingestellt werden kann, dadurch gekennzeichnet, daß eine molybdän-oragnische Verbindung in Gasform in eine Glimmentladungszone zersetzt wird.

2. Verfahren gemäß Anspruch 1, dadurch gekennzeichnet, daß Molybdänhexacarbonyl verwendet wird.

3. Verfahren gemäß Anspruch 1, dadurch gekennzeichnet, daß die Metallfilme auf einen Substrat abgeschieben werden.

4. Verfahren gemäß Anspruch 1, dadurch gekennzeichnet, daß der in der Glimmentladungszone erhaltene Metallfilm in einem Bad zur chemischreduktiven Metallabscheidung verstärkt wird.

5. Verfahren gemäß Anspruch 1, dadurch gekennzeichnet, daß die Strukturen durch Auflegen von Masken oder durch Auftragen von Siebdrucklacken oder Fotolacken vor der Plasmabehandlung vorgegeben werden.

6. Verfahren gemäß Anspruch 1, dadurch gekennzeichnet, daß die Strukturen nach der Plasmabehandlung mit Hilfe von Fotoresist, Fotolacken oder Siebdrucklacken erzeugt werden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | CHEMICAL ABSTRACTS, Band 96, 1982, Seite 520, Zusammenfassung Nr. 27739s, Columbus, Ohio, US; G.N. KARTMAZOV et al.: "Pyrolysis of molybdenum hexacarbonyl in glow discharge", & DEPOSITED DOC. 1980, VINIT, 5438-80, 11 pp * Zusammenfassung * | 1-3 | C 23 C 16/18<br>C 23 C 16/16<br>H 05 K 3/10<br>H 05 K 3/24<br>H 01 L 21/31 |
| X | THIN SOLID FILMS, Band 147, Nr. 2, März 1987, Seiten 193-202, Elsevier Sequoia, Lausanne, CH; N.J. IANNO et al.: "Plasma-enhanced chemical vapor deposition of molybdenum" * Seite 193, Zusammenfassung * | 1-3 | |
| A | EP-A-0 195 223 (SCHERING AG) * Ansprüche 1-4; Seite 1, Zeile 61 * | 1-6 | |
| A | GB-A- 939 095 (STANDARD TELEPHONES AND CABLES) * Ansprüche 1,5 * | 1 | RECHERCHIERTE SACHGEBIETE (Int. Cl.4)<br><br>C 23 C<br>H 05 K<br>H 01 L |

Der vorliegende Recherchenbericht wurde für alle Patentansprüche erstellt

| Recherchenort | Abschlußdatum der Recherche | Prüfer |
|---|---|---|
| DEN HAAG | 12-09-1988 | ELSEN D.B.A. |

EPO FORM 1503 03.82 (P0403)